# EUROPEAN PATENT APPLICATION

(11) **EP 4 417 731 A1**
(43) Date of publication of application: **21.08.2024**
(21) Application number: 22894684.4
(22) Date of filing: 09.11.2022
(51) Int. Cl.: C23C 16/32, C23C 16/458

(54) **REACTION CHAMBER AND REACTION DEVICE**

(30) Priority: 17.11.2021 CN 202111361303
(71) Applicant: Shenzhen Naso Tech Co., Ltd, Shenzhen, Guangdong 518107 (CN)
(72) Inventor: XIAO, Yunzhang, Shenzhen, Guangdong 518107 (CN); XU, Xin, Shenzhen, Guangdong 518107 (CN); HUANG, Shuaishuai, Shenzhen, Guangdong 518107 (CN); LIU, Lianghui, Shenzhen, Guangdong 518107 (CN); LIU, Jiaming, Shenzhen, Guangdong 518107 (CN); CHEN, Bingan, Shenzhen, Guangdong 518107 (CN); ZHONG, Guofang, Shenzhen, Guangdong 518107 (CN)
(74) Representative: Heeschen Pültz Patentanwälte PartGmbB
(86) International application number: PCT/CN2022/130889
(87) International publication number: WO 2023/088147

(57) **Abstract**

A reaction chamber (100) and a reaction device (200) are disclosed. The reaction chamber (100) includes a hollow heating member (20), a rotating platform, a protection plate assembly and a separator (70). The rotating platform is rotatably provided in an inner cavity (201) of the hollow heating member (20). The rotating platform is used for bearing a wafer. The protection plate assembly is provided on two sides of the rotating platform. The separator (70) is erected on the protection plate assembly. The separator (70) is matched with the protection plate assembly.

## Description

### FIELD OF THE INVENTION

The present disclosure relates to the field of chemical vapor deposition, and in particular to a reaction chamber and a reaction device.

### BACKGROUND OF THE INVENTION

A silicon carbide (SiC) material has been developed rapidly because of a huge utilization potentiality in high frequency, high voltage or high power devices. Due to few defects and orderly lattice arrangement of a SiC epitaxial layer, a SiC device is generally made only on an epitaxial layer. Chemical Vapor Deposition (CVD) is often used to prepare the SiC epitaxial layer. Deposition of the SiC epitaxial layer requires a very high temperature, therefore a graphite component with high temperature resistance is used in a reaction chamber. Under an action of a medium and high frequency induction current, an alternating magnetic field is generated inside the reaction chamber, and an alternating induction current generated in the graphite component can heat a temperature of the graphite to reach a required temperature for an epitaxy process. In order to improve an uniformity of a temperature distribution in the reaction chamber and a quality and a performance of the SiC epitaxial layer, the reaction chamber of a SiC epitaxial equipment mostly adopts a thermal wall type of reaction chamber, which has high temperatures across a wall surface thereof, such that the temperature distribution in the reaction chamber is more uniform than other types.

However, after introducing a reaction gas, the chemical vapor deposition will occur not only on a wafer surface, but also on an inner surface of the reaction chamber and a high-temperature wall surface of an air inlet channel to generate other crystal forms of silicon carbide particles. On one hand, the reaction gas involved in the reaction is consumed in a large quantity before reaching a wafer, thereby leading to a reduction of a utilization rate of the reaction gas and an increase of a cost. On the other hand, the falling off of the silicon carbide particles deposited on the high-temperature wall surface in an upstream of the wafer will further affect a quality and a performance of the epitaxial layer deposited on the wafer to some extent.

In addition to the above problems, after a certain batch of productions, due to accumulation of the silicon carbide particles on the high-temperature wall surface, the reaction chamber needs regular maintenances to remove the silicon carbide particles grown on the high-temperature wall surface in the reaction chamber or even replace the graphite component in the reaction chamber. Due to a complex shape of the graphite component in the reaction chamber and an inconvenience of cleaning, all components in the reaction chamber need to be replaced when necessary, resulting in a poor maintenance convenience and a long maintenance time for the reaction chamber, and a higher cost in a replacement of the graphite component in the reaction chamber.

### SUMMARY OF THE INVENTION

In order to overcome the shortages in the related art, the present disclosure provides a reaction chamber and a reaction device.

A reaction chamber provided by the present disclosure includes a hollow heating member, a rotating platform, a protection plate assembly and a separator. The rotating platform is rotatably arranged in an inner cavity of the hollow heating member. The rotating platform is configured to bear a wafer. The protection plate assembly is arranged on two sides of the rotating platform. The separator is erected on the protection plate assembly. The separator is configured to match with the protection plate assembly to divide a reaction cavity in the inner cavity. The rotating platform is surrounded in the reaction cavity, and an inner surface of the inner cavity is not exposed to the reaction cavity.

In a possible enforcement mode, the separator includes two oppositely arranged side baffles and an upper baffle connecting with the two side baffles. Each of the two side baffles is supported on a respective one of two sides of the protection plate assembly to match with the protection plate assembly to isolate the rotating platform from a side wall of the inner cavity, and the upper baffle isolates the rotating platform from a top wall of the inner cavity.

In a possible enforcement mode, the protection plate assembly includes a front protection plate and a rear protection plate. The front protection plate and the rear protection plate are respectively arranged at two sides of the rotating platform. The front protection plate includes two bearing surfaces at two sides thereof. The rear protection plate includes two supporting surfaces at two sides thereof. Each of the two side baffles includes a matching surface at a side thereof facing the front protection plate and the rear protection plate, and the matching surface is opposite to a respective one of the two bearing surfaces and a respective one of the two supporting surfaces. The matching surface is matched with the respective one of the two bearing surfaces and the respective one of the two supporting surfaces to support a respective one of the two side baffles on the front protection plate and the rear protection plate.

In a possible enforcement mode, the two bearing surfaces at two sides of the front protection plate are inclined planes opposite to each other. The supporting surfaces at two sides of the rear protection plate are inclined planes opposite to each other. The matching surface is one of two matching surfaces at the two side baffles, and the two matching surfaces are inclined planes opposite to each other, the two side baffles are thus positioned.

In a possible enforcement mode, the rear protection plate further includes a guide component. The guide component is arranged between the two supporting surfaces and extends from a side close to the rotating platform to another side close to an air outlet of the inner cavity.

In a possible enforcement mode, the two side baffles are integrally formed with the upper baffle.

In a possible enforcement mode, the separator includes at least two sub-separators along a flow direction of a reaction gas.

In a possible enforcement mode, the hollow heating member has a single annular structure, and the hollow heating member has equal thicknesses across respective positions.

In a possible enforcement mode, a rotating groove is arranged at a side of the rotating platform away from the separator. A driving cavity is further arranged on the hollow heating member. The driving cavity is arranged under a bottom wall of the inner cavity and extends to a middle of the inner cavity along an opening direction of the inner cavity, and the rotating groove is in fluid communication with the driving cavity.

In a possible enforcement mode, the hollow heating member further includes a temperature measuring cavity, and the temperature measuring cavity is arranged at a top wall of the inner cavity and extends to the middle of the inner cavity along an opening direction of the inner cavity.

In a possible enforcement mode, the reaction chamber further includes a heat insulation layer, and the heat insulation layer covers the hollow heating member.

In a possible enforcement mode, the heat insulation layer is uniformly coated outside the hollow heating member, and the heat insulation layer includes a plurality of sub-heat insulation members.

In a possible enforcement mode, the reaction chamber further includes a gas guiding member. The gas guiding member is located at a front end of the hollow heating member and is in fluid communication with the reaction cavity of the hollow heating member. The gas guiding member is configured to guide a reaction gas entering an air inlet of the heat insulation layer to the rotating platform in the reaction cavity.

In a possible enforcement mode, the gas guiding member comprises a plurality of graphite structures spliced up and down, and a contact surface of each of the plurality of graphite structures comprises an insulation layer or an insulation component.

In a possible enforcement mode, the gas guiding member has a single annular structure and is made of a non-conductive material.

In a possible enforcement mode, surfaces of the rotating platform, the protection plate assembly and the separator exposed to the reaction chamber further include a coating.

In a possible enforcement mode, the coating is a TaC coating.

In a possible enforcement mode, the inner cavity is one of two inner cavities of the hollow heating member, the two inner cavities are arranged up and down, and each of the two inner cavities comprises a rotating platform, a protection plate assembly and a separator.

In a possible enforcement mode, the protection plate assembly has an integral structure.

The present disclosure further provides a reaction device, which includes the reaction chamber as discussed above.

Compared with the related art, the present disclosure has the following beneficial effects.

The rotating platform, the protection plate assembly and the separator are simple in structure and low in cost. The rotating platform is surrounded in the reaction cavity which is surrounded by the separator and the protection plate assembly, so that the rotating platform is not exposed to the inner surface of the hollow heating member with a complicated structure and a high cost. When entering the hollow heating member, the reaction gas only flows through the reaction cavity. The wafer on the rotating platform is subjected to chemical vapor deposition, and a vapor deposition reaction occurs on the separator and the protection plate assembly, which results in excess deposition, and no deposition occurs on the surface of the hollow heating member. After a certain batch of process productions, it is only necessary to replace the rotating platform, the protection plate assembly and the separator with simple structures and low costs, and the hollow heating member with an expensive cost and a complex structure does not need to be maintained or replaced, which is convenient for maintenance and reduces the maintenance cost of the reaction chamber.

### BRIEF DESCRIPTION OF THE DRAWINGS

In order to explain the technical scheme of the embodiments of the present disclosure more clearly, the accompanying drawings needed to be used in the embodiments will be briefly introduced hereinafter. It should be understood that the following accompanying drawings only show some embodiments of the present disclosure, so as not to be regarded as the limitation to the scope. For those ordinary skilled in the art, other related accompanying drawings can be obtained according to these accompanying drawings without creative work.
FIG. 1 shows a schematic structural view of a reaction chamber according to an embodiment of the present disclosure;
FIG. 2 shows an exploded schematic view of the reaction chamber shown in FIG. 1;
FIG. 3 shows a front view of the reaction chamber shown in FIG. 1;
FIG. 4 shows a cross-sectional view taken along IV-IV of the reaction chamber shown in FIG. 3;
FIG. 5 shows a cross-sectional view taken along V-V of the reaction chamber shown in FIG. 4;
FIG. 6 shows a three-dimensional cross-sectional view of the reaction chamber shown in FIG. 1;
FIG. 7 shows a cross-sectional view taken along VII-VII of the reaction chamber shown in FIG. 3;
FIG. 8 shows a cross-sectional view taken along V-V of the reaction chamber according to another embodiment of the present disclosure;
FIG. 9 shows a schematic view of a hollow heating member according to another embodiment of the present disclosure;
FIG. 10 shows a schematic structural view of the reaction chamber according to another embodiment of the present disclosure;
FIG. 11 shows an exploded schematic view of the reaction chamber shown in FIG. 10;
FIG. 12 shows a front view of the reaction chamber shown in FIG. 10;
FIG. 13 shows a cross-sectional view taken along XIII-XIII of the reaction chamber shown in FIG. 12;
FIG. 14 shows a cross-sectional view taken along XIV-XIV of the reaction chamber shown in FIG. 13;
FIG. 15 shows a three-dimensional cross-sectional view of the reaction chamber shown in FIG. 10;
FIG. 16 shows a cross-sectional view taken along XVI-XVI of the reaction chamber shown in FIG. 12;
FIG. 17 shows a temperature simulation of the reaction chamber shown in FIG. 1;
FIG. 18 shows a schematic structural view of a reaction device according to an embodiment of the present disclosure.

Symbol description of main elements:
100-reaction chamber; 10-heat insulation layer; 101-heat insulation cavity; 102-air inlet; 103-air outlet; 104-temperature measuring hole; 105-driving hole; 20-hollow heating member; 201-inner cavity; 202-reaction cavity; 203-heating cavity; 204-temperature measuring cavity; 205-driving cavity; 206-rotating shaft groove; 30-rotating base; 31-rotating shaft; 32-rotating groove; 33-bearing component; 34-positioning groove; 40-tray; 41-positioning component; 42-placing component; 50-front protection plate; 51-bearing surface; 60-rear protection plate; 61-supporting surface; 62-guide component; 63-correcting component; 70-separator; 71-side baffle; 711-matching surface; 72-upper baffle; 80-gas guiding member; 200-reaction device; 211-quartz tube; and 212-induction coil.

### DETAILED DESCRIPTION OF THE EMBODIMENTS

The embodiments of the present disclosure will be described in detail hereinafter, examples of the embodiments are illustrated in the accompanying drawings, where the same or similar reference numerals indicate the same or similar elements or elements having the same or similar functions throughout. The embodiments described below with reference to the accompanying drawings are illustrative and are intended only to explain the present disclosure, and are not to be construed as limitations of the present disclosure.

In the description of the present disclosure, it should be understood that the terms "center", "longitudinal", "transverse", "length", "width", "thickness", "up", "down", "before", "after", "left", "right", "vertical", "horizontal", "top", "bottom", "inside", "outside", "clockwise", "anticlockwise", "axial direction", "radial direction" and "circumferential direction" indicating the orientation or position relations are indicating the orientation or position relationships shown in the accompanying drawings, which are only intended to facilitate and simplify the description of the present disclosure, and are not intended to indicate or imply that the device or element being referred to must have a particular orientation, or be constructed and operated in a particular orientation, and therefore shall not be construed as a limitation of the present disclosure.

In addition, the terms "first" and "second" are only for descriptive purposes, and are not to be understood as indicating or implying relative importance or implicitly indicating the quantities of indicated technical features. Therefore, the features defined as "first" or "second" may explicitly or implicitly include one or more such features. In the description of the present disclosure, "a plurality of" means two or more, unless otherwise specifically defined.

In the present disclosure, unless otherwise specified and limited, the terms "install", "connected", "connecting", "fix" and etc. shall be understood in a broad sense, for example, it may be a fixed connection, a detachable connection, or an integrated connection, or it may be a mechanical connection or an electrical connection, or it may be direct connection or indirect connection by an intermediary, or it may be an internal connection of two elements or the interaction between two elements. The specific meanings of the above terms in the present disclosure can be understood in a specific case by those ordinary skilled in the art.

In the present disclosure, unless otherwise specified and limited, a first feature "above" or "under" a second feature may be that the first and second features are in direct contact, or the first and second features are in indirect contact by an intermediary. Moreover, the first feature "over", "on" or "above" the second feature can mean that the first feature is directly above or obliquely above the second feature, or just mean that a horizontal height of the first feature is higher than that of the second feature. The first feature "under", "below" and "beneath" the second feature can mean that the first feature is directly or obliquely below the second feature, or just mean that a horizontal height of the first feature is smaller than that of the second feature.

Referring to FIG. 1, an embodiment of the present disclosure provides a reaction chamber 100. The reaction chamber 100 is configured to grow an epitaxial layer to obtain a product with the epitaxial layer, for example, a preparation a of SiC epitaxial layer device. The reaction chamber 100 can provide an internal environment with a uniform temperature to facilitate a deposition of the epitaxial layer, and the maintenance of internal structural components to reduce a maintenance cost of the reaction chamber 100.

Referring to FIG. 2, the reaction chamber 100 includes a heat insulation layer 10, a hollow heating member 20, a rotating platform, a protection plate assembly and a separator 70. The rotating platform, the protection plate assembly and the separator 70 are all arranged in the hollow heating member 20. The hollow heating member 20 is configured to provide a constant high temperature. The heat insulation layer 10 covers the hollow heating member 20. The heat insulation layer 10 is configured to reduce a heat loss generated by the hollow heating member 20.

Referring both to FIGS. 5 and 6, the hollow heating member 20 has horizontally openings. The rotating platform includes a rotating base 30 and a tray 40. The rotating base 30 is rotatably arranged in a middle of the hollow heating member 20, and a rotating shaft is arranged in a vertical direction. The tray 40 is arranged on the rotating base 30. The tray 40 is configured to bear a wafer to form an epitaxial layer on the wafer. The protection plate assembly includes a front protection plate 50 and a rear protection plate 60. The front protection plate 50 and the rear protection plate 60 are respectively arranged at two sides of the tray 40 and respectively extend to the two openings of the hollow heating member 20. The separator 70 is erected on the front protection plate 50 and the rear protection plate 60, and two sides of the separator 70 respectively extend to the two openings of the hollow heating member 20. The separator 70 is configured to seperate an inner cavity 201 of the hollow heating member 20 to form a reaction cavity 202 and a heating cavity 203 which are isolated from each other. The reaction cavity 202 is surrounded by the separator 70, the front protection plate 50 and the rear protection plate 60, and the tray 40 is surrounded in the reaction cavity 202. The reaction cavity 202 is used for an epitaxial reaction on the tray 40. The heating cavity 203 is formed by an inner wall of the hollow heating member 20 and the separator 70. The heating cavity 203 is configured to receive the heat generated by the hollow heating member 20 and transfer the heat to the reaction cavity 202 through the separator 70.

Specifically, the hollow heating member 20 is made of graphite, preferably high purity graphite. The hollow heating member 20 transfers the heat and the temperature to other internal components by means of heat conductions and heat radiations. Because graphite has a good thermal conductivity and high blackness, all other components in the reaction chamber 100 are made of graphite except the heat insulation layer 10 which is made of a heat insulation material. Therefore, the temperature in the whole reaction chamber 100 is basically equal, which ensures the smooth progress of an epitaxial deposition.

Furthermore, the hollow heating member 20 has a single annular structure, and a thickness of which at each position is less than a skin depth of the graphite at an induction power supply frequency. If the thicknesses across respective positions are equal, when the hollow heating member 20 is heated by means of an induction, the heat generated at each position is uniform and the temperature consistency is good.

In some embodiments, the heat insulation layer 10 may be formed by splicing a plurality of heat insulation members together which uniformly cover outside the hollow heating member 20.

Referring to FIG. 4, during the reaction, a reaction gas is introduced from a side of the hollow heating member 20, and the gas flows from the reaction cavity 202 to the wafer on the tray 40. Before reaching a wafer surface, the reaction gas has been heated to a certain temperature by a front end of the hollow heating member 20, and a good epitaxial layer is formed by a certain mechanism after the reaction gas reaches the wafer surface. Meanwhile, since the reaction cavity 202 is isolated from the heating cavity 203 exposing an inner surface of the hollow heating member 20 by the tray 40, the front protection plate 50, the rear protection plate 60 and the separator 70, a reaction of the reaction gas in the heating cavity 203 and deposition on the inner surface of the hollow heating member 20 are avoided.

As shown in FIGS. 3 and 5, since an internal space of the reaction cavity 202 is smaller, under a joint action of the heat insulation layer 10 covering the hollow heating member 20 and the separator 70 inside the hollow heating member 20, a temperature uniformity in the reaction cavity 202, especially on the wafer surface, can be more easily realized. The tray 40, the front protection plate 50, the rear protection plate 60 and the separator 70 are simple in structure and low in cost. The tray 40 is surrounded in the reaction cavity 202 formed by the separator 70, the front protection plate 50 and the rear protection plate 60, so that the tray 40 is not exposed to the inner surface of the hollow heating member 20 with a complex structure and a high cost. When entering the hollow heating member 20, the reaction gas only flows through the reaction cavity 202. The wafer on the tray 40 is subjected to the chemical vapor deposition. A vapor deposition reaction occurs on the separator 70, the front protection plate 50 or the rear protection plate 60, which results in excess deposition, but none of the reaction gas flows into the heating cavity 203, so that no deposition occurs on the surface of the hollow heating member 20. After a certain batch of process productions, only the tray 40, the front protection plate 50, the rear protection plate 60 and the separator 70 with simple structures and low costs have to be replaced. The hollow heating member 20 with an expensive cost and a complicated structure does not have to be maintained or replaced. As compared to the related art, a temperature uniformity in the reaction chamber is better, a utilization rate of the reaction gas is higher, a frequency of maintenance and replacement of various components in the reaction chamber is lower, a maintenance convenience is good, and a maintenance cost of the reaction chamber 100 is reduced.

Referring to FIG. 17 showing a temperature simulation view of the reaction chamber, it can be concluded from the drawing that in the reaction chamber 100 of the present disclosure, the temperature uniformity of the wafer surface is good, and a thin layer with a uniform thickness can be grown, so that a quality of a product can be improved.

Referring to FIGS. 1 to 7, a reaction chamber 100 provided by the embodiment can be applied to the growth of an epitaxial layer. The embodiment is an improvement on a technical basis of the above Embodiment 1. Compared with Embodiment 1, differences are as follows.

The heat insulation layer 10 includes a heat insulation cavity 101, an air inlet 102 and an air outlet 103. The hollow heating member 20 is arranged in the heat insulation cavity 101. The air inlet 102 and the air outlet 103 are located at two sides of the heat insulation cavity 101 and are in fluid communication with the heat insulation cavity 101 respectively. Each of the air inlet 102 and the air outlet 103 corresponds to a respective one of the two openings of the hollow heating member 20.

Each of the two openings of the hollow heating member 20 is roughly chamfered rectangle, and the rotating base 30, the front protection plate 50 and the rear protection plate 60 are respectively arranged on a bottom wall of the inner cavity 201.

Referring to FIGS. 1 to 7, the reaction chamber 100 provided by the embodiment can be applied to the growth of the epitaxial layer. The embodiment is an improvement on the technical basis of the above Embodiments 1 and 2. Compared with the above Embodiment 1, differences are as follows.

The front protection plate 50, the rear protection plate 60, and the tray 40 have flush surface heights.

Specifically, the rotating base 30 and the tray 40 are circular. A side of a respective one of the front protection plate 50 and the rear protection plate 60 facing the tray 40 has a semi-circular shape which maches the shape of the tray. The front protection plate 50 and the rear protection plate 60 are respectively arranged on the bottom wall of the inner cavity 201, and a circular reaction groove (without being labeled) is formed in the middle by the front protection plate 50 and the rear protection plate 60. The rotating base 30 and the tray 40 are almost completely filled in the reaction groove, and a surface of the tray 40 away from the rotating base 30 is flush with a side surface of each of the front protection plate 50 and the rear protection plate 60 away from the bottom wall of the inner cavity 201.

A component (not shown in the drawings) for limiting the front protection plate 50 and the rear protection plate 60 is configured on the bottom wall of the inner cavity 201, such as a limiting pin, a protrusion, a groove or other structures, and matches with the rotating shaft 31 and the rotating shaft groove 206 to ensure the fixing of installation relative positions of the front protection plate 50, the rear protection plate 60 and the rotating base 30.

The rotating base 30 includes a bearing component 33 at a side facing the tray 40. The bearing component 33 is configured to support the tray 40. In the embodiment, the bearing component 33 is a circular protrusion in the middle of the rotating base 30, and the tray 40 is placed on the circular protrusion.

In the embodiment, the bearing component 33 includes a positioning groove 34 at a side facing the tray 40. The positioning groove 34 is configured to position the tray 40. the tray 40 includes a positioning component 41 at a side facing the rotating base 30, and the tray 40 is positioned on the rotating base 30 by means of the matching of the positioning component 41 and the positioning groove 34. In the embodiment, the positioning groove 34 is a circular groove in a middle of the bearing component 33, and the positioning component 41 is a circular protrusion, but they are not limited to these. In other embodiments, the positioning groove 34 and the positioning component 41 may be in other shapes that match with each other.

The tray 40 includes a placing component 42 at a side away from the rotating base 30. The placing component 42 is configured to bear a wafer to form an epitaxial layer thereon. In the embodiment, the placing component 42 is a circular groove in a middle of the tray 40.

In some embodiments, the rotating base 30 and the tray 40 can also be integrally formed, that is, the rotating platform has a whole structure, and a wafer placing groove is formed in a middle of the rotating platform for bearing a wafer.

The separator 70 is roughly U-shaped, and a length of the separator 70 is equal to a length of the hollow heating member 20. The separator 70 includes two oppositely arranged side baffles 71 and an upper baffle 72 connecting with the two side baffles 71. The two side baffles 71 are respectively supported on two sides of each of the front protection plate 50 and the rear protection plate 60 to match with the front protection plate 50 and the rear protection plate 60, so as to isolate the tray 40 from a side wall of the inner cavity 201, and the tray 40 is isolated from a top wall of the inner cavity 201 by the upper baffle 72, therefore the tray 40 is isolated.

An inner surface and two inner side walls of the U-shaped separator 70 facing to the wafer are perfectly flat, so that heat is radiated to the wafer surface and positions of the wafer close to a wafer edge. In addition, the U-shaped separator has relatively uniform temperatures across respective positions thereof, so that heat transfers to the wafer surface from the rotating base 30 and the tray 40. Therefore, a better temperature uniformity can be achieved on the wafer surface, that is, the temperature differences between each of positions on the wafer surface are smaller.

In some embodiments, the two side baffles 71 are integrally formed with the upper baffle 72. However, it is not limited to this. One of the two side baffles 71 and the upper baffle 72 may further be spliced by two separate components. Specifically, each of the two side baffles 71 can be arranged on the front protection plate 50 and the rear protection plate 60, and then the upper baffle 72 is arranged on a top of the two side baffles 71. Alternately, the two side baffles 71 are spliced with the upper baffle 72 first and then placed on the front protection plate 50 and the rear protection plate 60 as long as the two side baffles 71 and the upper baffle 72 can match with the front protection plate 50 and the rear protection plate 60 to divide the inner cavity 201 of the hollow heating member 20 into the reaction cavity 202 and the heating cavity 203 which are separated from each other.

Specifically, the front protection plate 50 includes two bearing surfaces 51 on two sides of the reaction groove, and the rear protection plate 60 includes two supporting surfaces 61 on two sides of the reaction groove. Two matching surfaces 711 opposite to the two bearing surfaces 51 and the two supporting surfaces 61 are provided at a side of the two side baffles 71 facing the front protection plate 50 and the rear protection plate 60. The two side baffles 71 are supported on the front protection plate 50 and the rear protection plate 60 by matching the matching surface 711 with the bearing surface 51 and the supporting surface 61.

The two bearing surfaces 51 at two sides are inclined surfaces opposite to each other, and the two supporting surfaces 61 at two sides are inclined surfaces opposite to each other. A slope of one of the two bearing surfaces 51 is the same as a slop of a respective one of the two supporting surfaces 61. The two matching surfaces 711 of the two side baffles 71 are also inclined surfaces opposite to each other, and the two matching surfaces 711 are inclined in opposite directions and at the same angle as the corresponding bearing surface 51 and the corresponding supporting surface 61, so as to position the two side baffles 71.

In some embodiments, the front protection plate 50 and the rear protection plate 60 may further be integrally formed, that is, the protection plate assembly is a whole plate with a circular reaction groove in a middle for placing the rotating base 30 and the tray 40.

Referring to FIGS. 1 to 7, the reaction chamber 100 provided by the embodiment can be applied to the growth of the epitaxial layer. The embodiment is an improvement on the technical basis of the above Embodiments 1 to 3. Compared with the above Embodiment 3, the differences are as follows.

The reaction chamber 100 is further provided with a coating, which is configured to increase a binding force between a by-product in the reaction and a wall surface, and prevent the by-product generated by gas deposition in the reaction chamber 100 from falling off the wall surface and affecting a quality and an effect of the epitaxial layer deposited on the wafer surface.

The coating may be coated on other components except the hollow heating member 20 and the rotating base 30.

Specifically, the surfaces of the tray 40, the front protection plate 50, the rear protection plate 60, and the separator 70 on which deposition occurs may be treated with a uniform coating. Structures of these components are relatively simple, the cost is relatively low, and the coating is convenient, so that the later maintenance is convenient and the maintenance cost is obviously lower.

In some embodiments, the coating adopts a SiC coating. But it is not limited to this. In other embodiments, the coating adopts a TaC coating.

Referring to FIGS. 1 to 7, the reaction chamber 100 provided by the embodiment can be applied to the growth of the epitaxial layer. The embodiment is an improvement on the technical basis of the above Embodiments 1 to 4. Compared with the above Embodiment 4, the differences are as follows.

The separator 70 is composed of at least two sub-separators along the flow direction of the reaction gas. A plurality of the sub-separators are respectively supported on two sides of the front protection plate 50, or on two sides of the rear protection plate 60, or on two sides of both the front protection plate 50 and the rear protection plate 60, so as to jointly divide the inner cavity 201 into a reaction cavity 202 and a heating cavity 203.

In the reaction cavity 202, a concentration of the reaction gas at a side of the tray 40 close to the air inlet 102 is much higher than a concentration of the reaction gas at a side of the tray 40 close to the air outlet 103, so that more deposits are generated on a side of the separator 70 close to the air inlet 102. By means of dividing the separator 70 into a plurality of sub-separators, only the sub-separators close to the air inlet 102 are replaced during maintenance, or the replacement frequency of the sub-separators at a side close to the air inlet 102 is higher than that of the sub-separators at a side close to the air outlet 103, which can improve the maintenance efficiency and further save the maintenance cost.

Referring to FIGS. 1 to 7, the reaction chamber 100 provided by the embodiment can be applied to the growth of the epitaxial layer. The embodiment is an improvement on the technical basis of the above Embodiments 1 to 5. Compared with the above Embodiment 5, the differences are as follows.

Two sides of the tray 40 are respectively flush with two sides of the inner cavity 201, that is, the inner cavity 201 is almost completely covered by the tray 40.

Specifically, a cross section of the inner cavity 201 can be approximately square, and the tray 40 can be circular inscribed with the square. In Embodiments 1 to 6 the reaction gas deposits more on the front protection plate 50. Therefore, by means of maximizing the tray 40, as well as the front protection plate 50 and the rear protection plate 60 being made into a shape where the cross section of the inner cavity 201 does not overlap with the inscribed circular tray 40, the reaction gas entering the inner cavity 201 directly deposits on an upstream of the inner cavity 201, that is, on a side of the tray 40 close to the air inlet 102. Since the tray 40 is uniformly rotated, the reaction gas uniformly deposits on all parts of the wafer on the tray 40, and since the reaction gas can only deposit on the wafer surface on the tray 40, the by-products are reduced, and the maintenance frequency of each member in the reaction chamber 100 can further be reduced.

Referring to FIGS. 1 to 7, the reaction chamber 100 provided by the embodiment can be applied to the growth of the epitaxial layer. The embodiment is an improvement on the technical basis of the above Embodiments 1 to 6. Compared with the above embodiment 6, the differences are as follows.

The reaction chamber 100 is further provided with a gas guiding member 80. The gas guiding member 80 is located at a front end of a side of the hollow heating member 20 close to the air inlet 102, and the gas guiding member 80 penetrates through the air inlet 102 of the heat insulation layer 10 and is in fluid communication with the reaction chamber 202 of the hollow heating member 20. The gas guiding member 80 has a tubular structure and is configured to guide the reaction gas to enter the air inlet 102 to the tray 40 in the reaction cavity 202.

Since the inner cavity 201 is surrounded in the hollow heating member 20, and the hollow heating member 20 is heated under an action of an alternating magnetic field, the temperature in the inner cavity 201 rises to a higher temperature. After entering the inner cavity 201 from the air inlet 102, the reaction gas deposits on the side of the inner cavity 201 close to the air inlet 102 and consumes more, resulting in the waste of a raw gas and the reduction of a production speed.

In some embodiments, the gas guiding member 80 is formed by a plurality of graphite members spliced up and down, and insulation layers or insulation components are added on contact surfaces of the plurality of graphite members to insulate from each other, so that the heat generated by alternating induced current in the alternating magnetic field can be avoided, and the consumption of the reaction gas before reaching the wafer on the tray 40 can be obviously reduced, so that more reaction gas can reach the wafer surface, thereby improving the growth speed of the epitaxial layer and the utilization rate of the reaction gas. Moreover, because a temperature of the gas guiding member 80 is low, an inner surface of the gas guiding member 80 can not reach a temperature at which the reaction gas reacts to deposit particles, so that the consumption of the reaction gas flowing through the gas guiding member 80 is less, and a speed of gas deposition on the gas guiding member 80 is low, which improves the utilization rate of the reaction of the reaction gas on the wafer surface, basically eliminates the possibility that the generated particles on the inner surface of the gas guiding member 80 will fall off and affect the wafer surface quality, and reduces the maintenance frequency of the gas guiding member 80. Meanwhile, deposition of the reaction gas on the front end of the front protection plate 50 and the hollow heating member 20 is reduced, so that a damage to the wafer surface caused by the falling off of the deposited particles is reduced to a certain extent, defects of wafer growth are reduced, and a performance and a quality of the wafer are improved.

In other embodiments, the gas guiding member 80 is made of other non-conductive materials, which can further avoid a phenomenon that alternating induced current is generated to generate heat and cause a temperature to rise. At this time, the gas guiding member 80 may be in an annular structure which is integrally processed. For example, the gas guiding member 80 is made of a high-temperature resistant polycrystalline silicon carbide.

Referring to FIGS. 1 to 8, the reaction chamber 100 provided by the embodiment can be applied to the growth of the epitaxial layer. The embodiment is an improvement on the technical basis of the above Embodiments 1 to 7. Compared with the above Embodiment 7, the differences are as follows.

The inner cavity 201 includes two inner cavities arranged up and down, and the epitaxial layers can be grown on each of two wafers at the same time to improve the production efficiency.

Specifically, referring to FIG. 8, each of the two inner cavities 201 includes a rotating base 30, a tray 40, a front protection plate 50, a rear protection plate 60 and a separator 70, and each of the two inner cavities 201 is divided into a reaction cavity 202 and a heating cavity 203.

Further, referring to FIG. 9, in order to improve the temperature uniformity of a surface of each of the two wafers on the tray 40, in some embodiments, the hollow heating member 20 may be designed with a multi-layer distribution structure. During induction heating, neither the rotating base 30 with the wafer nor the graphite layer of the hollow heating member 20 at the bottom of the tray 40 generates heat. The heat is transferred to the tray 40 and the wafer by the high temperature generated by the heating of the circular graphite layer in the peripheral region, and the non-heating layer above the wafer radiates heat to the wafer surface, which are combined to improve the temperature uniformity of the surface of each of the two wafers.

Referring to FIGS. 10 to 16, the reaction chamber 100 provided by the embodiment can be applied to the growth of the epitaxial layer. The embodiment is an improvement on the technical basis of the above Embodiments 1 to 8. Compared with the above Embodiment 1, the differences are as follows.

The hollow heating member 20 is further provided with a temperature measuring cavity 204. The temperature measuring cavity 204 is arranged at the top wall of the inner cavity 201 and extends to a middle of the inner cavity 201 along an opening direction of the inner cavity 201. The heat insulation layer 10 includes a temperature measuring hole 104 corresponding to the temperature measuring cavity 204. During epitaxial deposition, a temperature measuring device can be arranged in the reaction chamber 100 through the temperature measuring hole 104 and the temperature measuring cavity 204, and a temperature close to the tray 40 can be monitored when an epitaxial reaction occurs, so as to keep the temperature consistent with a process temperature, which is beneficial to the deposition of the epitaxial layer.

The rotating base 30 is driven to rotate by gas. The rotating base 30 is arranged at the bottom wall of the inner cavity 201 by the rotating shaft 31. The rotating base 30 includes a rotating groove 32 at a side of away from the tray 40. By injecting the gas into the rotating groove 32, the rotating base 30 is driven to rotate around the rotating shaft 31.

Specifically, the hollow heating member 20 is further provided with a driving cavity 205. The driving cavity 205 is arranged below the bottom wall of the inner cavity 201, and extends to the middle of the inner cavity 201 along the opening direction of the inner cavity 201, and is in fluid communication with the inner cavity 201 at the middle of the inner cavity 201. The bottom wall of the inner cavity 201 is further provided with a rotating shaft groove 206. The rotating shaft 31 is rotatably arranged in the rotating shaft groove 206. The rotating groove 32 can be in fluid communication with the driving cavity 205 to drive the rotating base 30 to rotate. The heat insulation layer 10 includes a driving hole 105 corresponding to the driving cavity 205. During an epitaxial deposition, a driving gas can be introduced into the rotating groove 32 through the driving hole 105 and the driving cavity 205 to rotate the rotating base 30.

In some embodiments, at least two rotating grooves 32 are provided, and the at least two rotating grooves 32 are rotatably symmetrical about the rotating axis of the rotating base 30. At least two communication points are provided between the driving cavity 205 and the inner cavity 201, and the at least two communication points are rotatably symmetrical about a center of the rotating shaft groove 206 to correspond with the rotating groove 32.

In other embodiments, the rotating base 30 may be driven to rotate in other ways, such as by electrical or mechanical transmissions, etc. By configuring a hole in the bottom wall of the inner cavity 201 of the hollow heating member 20, a driving shaft of a motor or a rotary cylinder can be connected to the rotating base 30 through the hollow heating member 20.

Referring to FIGS. 14 to 16, the rear protection plate 60 is further provided with a guide component 62. The guide component 62 is configured to guide an entry and an exit of a handling device for loading and unloading the tray 40. In some embodiments, the handling device is a mechanical hand. The guide component 62 is arranged between the two supporting surfaces 61, and extends from a side close to the tray 40 to a side close to the air outlet of the hollow heating member 20, so that the handling device can enter and exit the reaction cavity 202 to take or place the tray 40 with the wafer.

Further, the guide component 62 includes two parallel grooves arranged on the rear protection plate 60, and the two grooves are respectively close to a respective one of the two supporting surfaces 61. The guide component 62 may further enable the gas that drives the rotating base 30 to rotate flow out of the rotating groove 32 and then flow out of the reaction chamber 100 through the guide component 62, so as to avoid an influence on the deposition of the reaction gas on the wafer surface.

The rear protection plate 60 is further provided with a correcting component 63. The correcting component 63 is configured to correct a traveling distance of the handling device to determine a relative position thereof. In some embodiments, the correcting component 63 is a groove arranged beside a respective one of the two parallel grooves of the guide component 62, so as to match with the guide component 62 to form a stepped structure. However, it is not limited to this. In other embodiments, the correcting component 63 may further be a protrusion, a pin or other structures.

Referring to FIGS. 1 to 18, the embodiment further provides a reaction device 200 configured to perform a processing to obtain an epitaxial layer. The reaction device 200 includes the reaction chamber 100 according to any one of the above Embodiments 1 to 9.

The reaction device 200 further includes a quartz tube 211 and an induction coil 212. The reaction chamber 100 is located in the quartz tube 211. The induction coil 212 is arranged outside the quartz tube 211. When an alternating current is applied to the induction coil 212, Joule heat can be generated inside the hollow heating member 20, so that a temperature in the reaction chamber 100 rises up.

Specifically, the quartz tube 211 is a double-layer casing pipe, and cooling water is introduced into an interlayer of the double-layer casing pipe to ensure that a temperature of the outermost side wall surface of the quartz tube 211 is not higher than 50°C, so as to avoid a scalding accident.

In the description of the specification, referring to the description of the terms "an embodiment", "some embodiments", "an example", "a specific example" or "some examples" means that specific features, structures, materials or characteristics described in combination with the embodiment or the example are fallen in at least one embodiment or example of the present disclosure. In the specification, the schematic expressions of the above terms are not necessarily aimed at the same embodiment or example. Moreover, the specific features, structures, materials or characteristics described may be combined in any one or more embodiments or examples in a suitable manner. In addition, those skilled in the art can join and combine the different embodiments or examples and the features of different embodiments or examples described in the specification without contradicting each other.

Although the embodiments of the present disclosure have been shown and described above, it can be understood that the above embodiments are exemplary and cannot be understood as limitations of the present disclosure, and changes, modifications, substitutions and variations to the above embodiments can be made by those ordinary skilled in the art within the scope of the present disclosure.

## Claims

1. A reaction chamber, comprising a hollow heating member, a rotating platform, a protection plate assembly and a separator, wherein the rotating platform is rotatably arranged in an inner cavity of the hollow heating member, wherein the rotating platform is configured to bear a wafer, wherein the protection plate assembly is arranged on two sides of the rotating platform, wherein the separator is erected on the protection plate assembly, wherein the separator is configured to match with the protection plate assembly to divide a reaction cavity in the inner cavity, wherein the rotating platform is surrounded in the reaction cavity, and an inner surface of the inner cavity is not exposed to the reaction cavity.

2. The reaction chamber according to claim 1, wherein the separator comprises two oppositely arranged side baffles and an upper baffle connecting with the two side baffles, each of the two side baffles is supported on a respective one of two sides of the protection plate assembly to match with the protection plate assembly to isolate the rotating platform from a side wall of the inner cavity, and the upper baffle isolates the rotating platform from a top wall of the inner cavity.

3. The reaction chamber according to claim 2, wherein the protection plate assembly comprises a front protection plate and a rear protection plate, wherein the front protective plate and the rear protective plate are respectively arranged at two sides of the rotating platform, wherein the front protection plate comprises two bearing surfaces at two side thereof, wherein the rear protection plate comprises two supporting surfaces at two side thereof, wherein each of the two side baffles comprises a matching surface at a side thereof facing the front protection plate and the rear protection plate, and the matching surface is opposite to a respective one of the two bearing surfaces and a respective one of the two supporting surfaces, wherein the matching surface is matched with the respective one of the two bearing surfaces and the respective one of the two supporting surfaces to support a respective one of the two side baffles on the front protection plate and the rear protection plate.

4. The reaction chamber according to claim 3, wherein the two bearing surfaces at two sides of the front protection plate are inclined planes opposite to each other, wherein the two supporting surfaces at two sides of the rear protection plate are inclined planes opposite to each other, wherein the matching surface is one of two matching surfaces at the two side baffles, and the two matching surfaces are inclined planes opposite to each other, the two side baffles are thus positioned.

5. The reaction chamber according to claim 3 or 4, wherein the rear protection plate further comprises a guide component, and the guide component is arranged between the two supporting surfaces and extends from a side close to the rotating platform to another side close to an air outlet of the inner cavity.

6. The reaction chamber according to any one of claims 2 to 5, wherein the two side baffles are integrally formed with the upper baffle.

7. The reaction chamber according to any one of claims 2 to 6, wherein the separator comprises at least two sub-separators along a flow direction of a reaction gas.

8. The reaction chamber according to any one of claims 1 to 7, wherein the hollow heating member has a single annular structure, and the hollow heating member has equal thicknesses across respective positions.

9. The reaction chamber according to any one of claims 1 to 8, wherein a rotating groove is arranged at a side of the rotating platform away from the separator, a driving cavity is further arranged on the hollow heating member, the driving cavity is arranged under a bottom wall of the inner cavity and extends to a middle of the inner cavity along an opening direction of the inner cavity, and the rotating groove is in fluid communication with the driving cavity.

10. The reaction chamber according to any one of claims 1 to 9, wherein the hollow heating member further comprises a temperature measuring cavity, and the temperature measuring cavity is arranged at a top wall of the inner cavity and extends to the middle of the inner cavity along an opening direction of the inner cavity.

11. The reaction chamber according to any one of claims 1 to 10, wherein the reaction chamber further comprises a heat insulation layer, and the heat insulation layer covers the hollow heating member.

12. The reaction chamber according to claim 11, wherein the heat insulation layer is uniformly coated outside the hollow heating member, and the heat insulation layer comprises a plurality of sub-heat insulation members.

13. The reaction chamber according to claim 11 or 12, wherein the reaction chamber further comprises a gas guiding member, wherein the gas guiding member is located at a front end of the hollow heating member and is in fluid communication with the reaction cavity of the hollow heating member, and the gas guiding member is configured to guide a reaction gas entering an air inlet of the heat insulation layer to the rotating platform in the reaction cavity.

14. The reaction chamber according to claim 13, wherein the gas guiding member comprises a plurality of graphite structures spliced up and down, and a contact surface of each of the plurality of graphite structures comprises an insulation layer or an insulation component.

15. The reaction chamber according to claim 13, wherein the gas guiding member has a single annular structure and is made of a non-conductive material.

16. The reaction chamber according to any one of claims 1 to 15, wherein surfaces of the rotating platform, the protection plate assembly and the separator exposed to the reaction chamber further comprise a coating.

17. The reaction chamber according to claim 16, wherein the coating is a TaC coating.

18. The reaction chamber according to any one of claims 1 to 17, wherein the inner cavity is one of two inner cavities of the hollow heating member, the two inner cavities are arranged up and down, and each of the two inner cavities comprises a rotating platform, a protection plate assembly and a separator.

19. The reaction chamber according to any one of claims 1 to 18, wherein the protection plate assembly has an integral structure.

20. A reaction device, comprising the reaction chamber according to any one of claims 1 to 19.
